# EUROPEAN PATENT APPLICATION

(11) **EP 2 660 865 A1**
(43) Date of publication of application: **06.11.2013**
(21) Application number: 12166133.4
(22) Date of filing: 30.04.2012
(51) Int. Cl.: H01L 29/739, H01L 29/74, H01L 29/861, H01L 29/40, H01L 29/78, H01C 7/105

(54) **High voltage semiconductor device with non-linear resistively graded edge termination**

(71) Applicant: ABB Technology AG, 8050 Zürich (CH)
(72) Inventor: Schuderer, Jürgen, 8047 Zürich (CH); Donzel, Lise, 5430 Wettingen (CH); Greuter, Felix, 5406 Baden-Rütihof (CH); Klaka, Sven, 5245 Habsburg (CH)
(74) Representative: ABB Patent Attorneys

(57) **Abstract**

A high voltage semiconductor device (1) with an improved edge termination arrangement is proposed. The high voltage semiconductor device (1) comprises a semiconductor substrate (2) with at least two differently doped regions (3, 4) and at least one junction (5) at which the two differently doped regions (3, 4) adjoin and an edge termination (9) at which the junction (5) reaches a surface of the semiconductor substrate (2). The edge termination (9) is covered by a grading layer (8) comprising a material having highly non-linear electrical resistivity characteristics due to an incorporation of microvaristors having an internal boundary structure. Electrical characteristics of the grading layer (8) comprising the microvaristors may be adapted to the specific requirements of the semiconductor device, particularly to its rated maximum voltage and to the length of the grading layer. Due to the highly non-linear electrical resistivity characteristics of the grading layer (8), critical local enhancements of an electric field adjacent to the edge termination may be prevented while at the same time keeping any leakage currents and frequency dependencies small.

## Description

### FIELD OF THE INVENTION

The present invention relates to the field of high voltage semiconductor power devices and more particularly to an edge termination arrangement for such device.

### TECHNICAL BACKGROUND

High voltage semiconductor devices, also referred to as power devices, such as power rectifiers, thyristors, insulated gate bipolar transistors and diodes, are typically used to rectify or switch substantial electric powers at voltages exceeding e.g. 2 kV. Particularly thyristor devices are produced typically with an entire wafer serving as a substrate for implementing a single high voltage semiconductor device. Therein, the wafer substrate may be of a semiconducting material such as silicon thereby providing a first region having a first doping type and doping concentration. At this substrate, at least one second region having another doping type and possibly having another doping concentration may be formed. Thereby, a junction is formed at which the first and second region adjoin. For example, in a power rectifier, a pn-junction is formed between a base region and an emitter region.

A thyristor typically comprises four layers of alternating n and p-type regions forming three pn junctions. The main terminals are labeled anode and cathode. A thyristor doping profile consists typically of a p-doped anode region, followed by the n-basis, then p-basis and an n-doped cathode region. Typically, the pn junction between n- and p-basis is the fundamental blocking junction of the device. The control terminal, called gate, is attached to the p-type region near to the cathode.

For devices with reverse blocking capability it is also possible that the blocking junction changes by the polarity reversal, e.g., from the p-base / n-base junction to the n-base / p-anode region junction.

Typically, in power devices, the geometry of the doping regions, i.e. particularly of the above mentioned first and second region, is adapted such that the blocking junction has a maximum area. However, due to the limited size of a wafer and additionally due to fabrication techniques, the junction always adjoins the surface of the wafer at some locations. These locations, which are referred to as edge termination, are known to be of critical influence onto characteristics of the power device.

One important parameter determining a quality of a high voltage semiconductor device is its breakdown voltage. With increasing voltage applied to a power device, the electric field increases. At prone local positions, a critical field strength may be exceeded, local discharging may occur and the device may break down. For secure operation of a power device, a rated maximum voltage Vₘₐₓ of the power device should be significantly smaller than its breakdown voltage. Therein, the rated maximum voltage Vₘₐₓ corresponds to a maximum voltage applied to the power device which should not be exceeded during normal operation, i.e. an upper limit of a rated voltage range of the high voltage semiconductor device should correspond to the rated maximum voltage.

One typical prone location of a power device is the edge termination where the junction reaches a surface of the semiconductor substrate. At such edge termination, high local electric fields may occur. Whether or not the electric field strength locally exceeds a discharging limit may depend on several parameters such as the geometry of the substrate, properties of the substrate surface adjacent to the edge termination, doping profiles in the doped regions, materials in the neighborhood of the edge termination, etc.

A conventional technique for reducing local field strengths at edge terminations of a power device uses bevels formed at these critical locations. An effect of the bevels may rely on the fact that equipotential lines must intersect a surface of the semiconductor substrate orthogonally, as long as there are no surface charges, and this generally forces the space charge region to widen at the edge termination thereby locally lowering the electric field strength at the surface.

In order to form the bevels at the edge termination of a power device, semiconductor material has to be precisely removed at the edges of the wafer using e.g. grinding or etching processes. Subsequently, etching of the bevel surface and depositing of a surface passivation layer may be applied in order to improve characteristics of the semiconducting material which may have been deteriorated during the processing for creating the bevels. Finally, the edge termination region may be encapsulated by a polymeric insulator such as e.g. a rubber.

Two different types of beveling may be applied to power devices. Positive beveling is preferably applied to a termination of a single high-voltage junction within high voltage power diodes. Negative beveling is preferably used for a termination of a forward blocking junction of a thyristor. Both approaches may result in reduced surface electric field strength compared to a parallel-plane, non-beveled substrate and thereby prevent e.g. flashover along a wafer surface.

However, forming of bevels and the presence of bevels in power device may have drawbacks. For example, a process of grinding used for generating the bevels may require substantial efforts and may need abrasive powders which during grinding may induce damages in the semiconductor material which may then require further processing such as etching and passivation. Furthermore, the presence of negative bevels may lead to reduced breakdown strength for the semiconductor bulk when compared to a parallel-plane junction. Additionally, negative beveled edges may not be well cooled as there may be considerably volume of the semiconductor bulk that is not in close contact to a heat sink such as a metal plate.

Other approaches for protecting edge terminations of power devices use material layers of selected linear electrical resistivity or high permittivity covering the edge termination. JP 2010-003762 discloses a high breakdown voltage semiconductor device comprising a non-linear resistance film formed in an electric field relaxation region. Film materials used therein however typically show a strong interdependence of a low-field resistivity and a switching field strength, which both are controlled by the particle size. A transition from the high resistivity at low fields to lower resistivity at higher field strength is not very sharp and may lead to unacceptably high leakage currents and power losses.

Such approaches frequently do not provide for satisfying device characteristics or exhibit negative side-effects such as high leakage currents and frequency dependencies.

### DISCLOSURE OF THE INVENTION

There may be a need to provide an alternative and improved approach for providing a high voltage semiconductor device with an edge termination. Particularly, there may be a need for an edge termination structure in a high voltage semiconductor device which does not require any beveling processing and which preferably results in high quality semiconductor device characteristics such as e.g. high breakdown voltage, low leakage currents and/or low frequency dependence.

These objects may be met by the subject matter of the independent claim of the present application. Embodiments of the invention are described with respect to the dependent claims.

According to an aspect of the present invention, a high voltage semiconductor device is proposed comprising a semiconductor substrate with at least two regions of different conductivity types and a junction at which the two differently doped regions adjoin. At an edge termination of the device the junction reaches a surface of the semiconductor substrate. Therein, the edge termination is covered by a grading layer comprising a matrix material. Into the matrix material, microvaristors are incorporated. The microvaristors have an internal boundary structure. Due to the microvaristors with their internal boundary structure, the grading layer has highly non-linear electrical resistivity characteristics.

The proposed approach for an edge termination structure may enable a high voltage semiconductor device to have a planar geometry. Planar geometry shall mean that the device comprises on two opposite main sides of the substrate electrical contacts and that the edge is arranged perpendicular to the two main sides of the substrate and thereby, laterally to the electrical contacts and orthogonal to them. In other words, no beveling is required for preventing excessive electric fields at the edge terminations. The approach may be beneficial especially for semiconductor power devices having a rated maximum voltage of above 2 kV such as e.g. power rectifiers, thyristors or diodes. The surface, on which the edge termination reaches the surface of the substrate, is one of these main sides.

An idea of the present invention may be seen in providing a new design and material composition for an edge termination of a high voltage semiconductor device. Therein, the edge termination, i.e. a critical location at which the junction of the device reaches the device surface, is covered by grading layer having a highly non-linear electrical resistivity characteristics due to an incorporation of microvaristors.

The non-linear electrically resistive material of the grading layer is preferably adapted to have suitable electrical switching field strength characteristics. Therein, the switching field strength E_{switch} may be defined as the electric field strength at which the material switches from a highly electrically insulating mode into highly electrically conductive mode. On the one hand, a grading layer consisting of such non-linear electrical material may remain insulating during normal operation voltages of the power device and may prevent undesired leakage currents. On the other hand, at high field stresses, the grading layer may become locally conductive and may thereby efficiently reduce local electric field enhancements that might otherwise lead to flashover or electrical breakdown.

Accordingly, application of a grading layer with highly non-linear resistivity characteristics onto an edge termination region may prevent the need for any beveling of the semiconductor substrate in such region. Thereby, also the need for providing effort and costs associated with the preparation of bevels and possibly any required post-processing may be omitted.

Compared to covering the edge termination region with a layer of linear resistivity or of high permittivity, using a highly non-linear resistive field grading layer may beneficially result in a more efficient suppression of local field enhancements and a reduced frequency dependence of the field grading at the edge termination.

The grading layer has a minimum length L in a direction along a surface of the semiconductor substrate and orthogonal to the termination edge, the minimum length being the length between the termination edge and a peripheral end of the grading layer or the length between the termination edge and an opposite contact of the semiconductor device. The electrical characteristics of the grading layer and in particular of the microvaristors comprised in the grading layer may then be adapted such that a switching field strength E_{switch} of the grading layer is higher than 0.5 times, preferably higher than 0.7 times, the maximum rated voltage Vₘₐₓ of the high voltage semiconductor device divided by the length L. Expressed in a different way, characteristics of the microvaristors may be adapted such that the requirement of E_{switch} ≥ 0.5 * (Vₘₐₓ / L), preferably E_{switch} ≥ 0.7 * (Vₘₐₓ/L) is fulfilled.

For example, the grading layer may have a length L of e.g. less than a few millimeters starting at the termination edge and extending in a direction orthogonal to a line defined by the termination edge preferably up to contacts on the two main sides of the power device, which sides are arranged opposite to each other. For example, the grading layer may bridge upper and lower contacts of the power device. For example, a 9 kV rated thyristor with a length of the grading layer of 2 mm, e.g. between upper and lower electrodes of a power device, may require a switching field strength E_{switch} of preferably 3.2 kV/mm or more to efficiently grade an electrical field near the edge termination and avoid excessive leakage currents.

A material of the grading layer has a non-linearity coefficient α of a characteristic current density - electric field strength - curve, i.e. of a curve representing a dependency j(E) of the current density j from the electric field strength E, fulfilling j ∼ E^{α}. For the proposed grading layer, the non-linearity coefficient α should be larger than 10, preferably larger than 15 and more preferably larger than 20 above the switching field strength E_{switch}. Thus, a sharp transition between insulating and conducting mode may be reached at a well-defined switching field strength. Large non-linearity coefficients may reduce leakage currents and may provide for a penetration length, i.e. a length over which the material is suppressing the local electrical field that is not much affected by a frequency.

The grading layer comprises a preferably insulating matrix material filled with first particles microvaristors having highly non-linear electrical resistivity characteristics. In other words, the grading layer may comprise a high breakdown strength matrix material and into this matrix material microvaristors are incorporated, these microvaristors providing for the desired highly non-linear electrical resistivity characteristics. For example, microvaristor particles may be filled at between 20 and 60 vol-%, preferably between 35 and 45 vol-% into the matrix material.

Therein, the microvaristors may have dimensions in a range of e.g. 10 µm to 200 µm. Microvaristors are tiny electroceramic particles which have highly non-linear, voltage controlled electrical transport properties and may therefore be used as active filler in a variety of insulating matrix materials for functional composites. For example, microvaristors may be produced by spray drying of a water-based slurry containing ZnO and different dopants. The particles may then be sintered at temperatures , e.g. above 1273 K. Processing parameters during the sintering process typically determine the development of grain boundary structures in the particles that are responsible for the non-linear electrical properties.

Due to their internal boundary structure, each individual microvaristor particle may show IV-characteristics similar to the ones known from bulk varistor ceramics, except for a scaled down switching voltage. By controlling and specifically adapting a material formulation, a particle size and/or sintering conditions, the switching characteristics may be tailored for specific applications, i.e. a switching field strength E_{switch} may be adapted to the specific requirements of a semiconductor device depending e.g. on the length L of the grading layer. The microvaristors can show internal boundary structures as known from metal- oxide varistors or from metal-insulator varistors as e.g. described by M.Weimer et.al. (Applied Phys. Letters 92 (2008) 164101). Typically, microvaristors may withstand high current loadings without major changes in their electrical properties. Due to the nature of the internal boundary structures the microvaristors may also show an enhanced permittivity and a temperature dependence of the transport properties, which may be weaker than for simple particle fillers, which are advantageous features of a field grading material. As the electrical properties are determined by the internal boundary structure rather than the particle-particle contacts in conventional field grading composites, they are also much more robust to processing parameters and to possible negative influences from external parameters such as mechanical stresses, humidity etc.

For example, the microvaristors having internal boundary structures may be based on a filler material like zinc oxide (ZnO), tin oxide (Sn0₂), titanium oxide (Ti0₂) or any other titanate (e.g. SrTiOₛ). Microvaristors based on ZnO have, in particular, been found to reveal advantageous electrical properties, especially with respect to non-linear electrical resistivity and tunability of the switching field strength. The filler material is doped with a dopant such as Bi, Sb, Mn, Co or Al. The filler material is sintered after spray-drying. By this process agglomerates are formed which have a number of grain boundaries inside. The number of grain boundaries and the electrical properties are adjusted by choosing a sintering temperature, typically between 935 °C to 1320 °C and sintering times which may vary from about 4 to 20 h. Thus, microvaristors are sintered particles of a filler material doped with a dopant. The sintered particles have an internal grain boundary structure, which is responsible for a nonlinear electrical property of the sintered particles. These sintered particles behave as a varistor, i.e. that a current flowing through the particle depends in a nonlinear way on the electric field strength. Such microvaristors are known from "Silicone composites for HV applications based on microvaristors", by L. Donzel et al., Internat. Conf. on Solid Dielectrics, Toulouse, 2004 or "Smart varistor composites" by Strümpler et al., Proc. of the 8th CIMETEC-World Ceramic Congress and Forum on New Materials, Symp. VI, 1994, which documents are incorporated by reference for the definition of microvaristors.

The microvaristors may be incorporated in any insulating matrix material. For example, the matrix material may comprise an elastomeric material, a thermoplastic material, a thermosetting material, a gel and/or a glazing or glasses. For example silicone rubber as is conventionally used to encapsulate high voltage semiconductor devices has been found to form a suitable matrix material. The grading material may completely enclose an edge of the semiconductor device. Alternatively, the grading layer may cover only a partial area of the substrate surface in the direct neighborhood of the edge termination. The grading layer may have a sufficient thickness to handle the local power densities from the field grading action and to keep the fields at their outer surfaces below an acceptable level for the packaging of the power device. This grading layer simultaneously also may act as a mechanical protection layer.

The sintered first particles, i.e. microvaristors, forming the electrically non-linear filler of the matrix material may have a certain granularity. Typically, microvaristors have a substantial size of more than 10 µm. It might therefore happen that on a microscopic level the surface area of the edge termination is not completely covered with such first microvaristor particles and localized field enhancements might occur e.g. at cavities of a sphere packing. In order to improve the grading of the edge termination, the small second grading particles may be embedded into the insulating matrix, wherein these second particles typically comprise a semiconductor or a high permittivity material.

These second particles may have significantly smaller dimensions than the first particles (microvaristors). For example, a majority of the microvaristors (i.e. more than 50 %) may have particle sizes of more than 10 µm, preferably more than 20 µm, whereas a majority of the linear grading particles may have particle sizes of less than 10 µm, preferably less than 3 µm. Adding such micron-sized or sub-micron-sized second filler particles may serve for achieving a refractive or resistive field grading on a micrometer scale or sub-micrometer scale. For refractive grading, a high permittivity material such as barium titanate (BaTiO₃), titanium oxide (TiO₂) or other titanates may be used. For resistive grading, semiconducting filler particles comprising e.g. tin oxide (SnO₂), carbon based filler such as black carbon, graphene, graphene oxide etc. and/or coated micro-mica may be used as preferred material candidates. The second small particles may show linear or nonlinear electrical resistivity and/or high permittivity. Due to their small size, the second particles may fill free spaces between the large first microvaristor particles.

Due to the additional incorporation of such small second particles, the field grading capability of the grading layer may be significantly enhanced as the resistive or refractive field grading provided by the small second particles may add to an overall grading effect additionally to the non-linear grading effect provided by the large microvaristor particles.

It is also possible to combine different field grading layers in a specific geometry around an edge termination. For example, a layer of high-permittivity material or of high switching field strength may be arranged close to a metallization edge combined with a low-switching field strength layer.

It has to be noted that aspects and embodiments of the present invention are described herein with reference to different subject-matters. A person skilled in the art will gather from the above and the following description that, unless other notified, in addition to any combination of features belonging to one type of subject-matter also any combination between features relating to different subject-matters is considered to be disclosed with this application.

### BRIEF DESCRIPTION OF THE DRAWING

The embodiments of the invention will be explained in more detail in the following text with reference to the attached drawing.

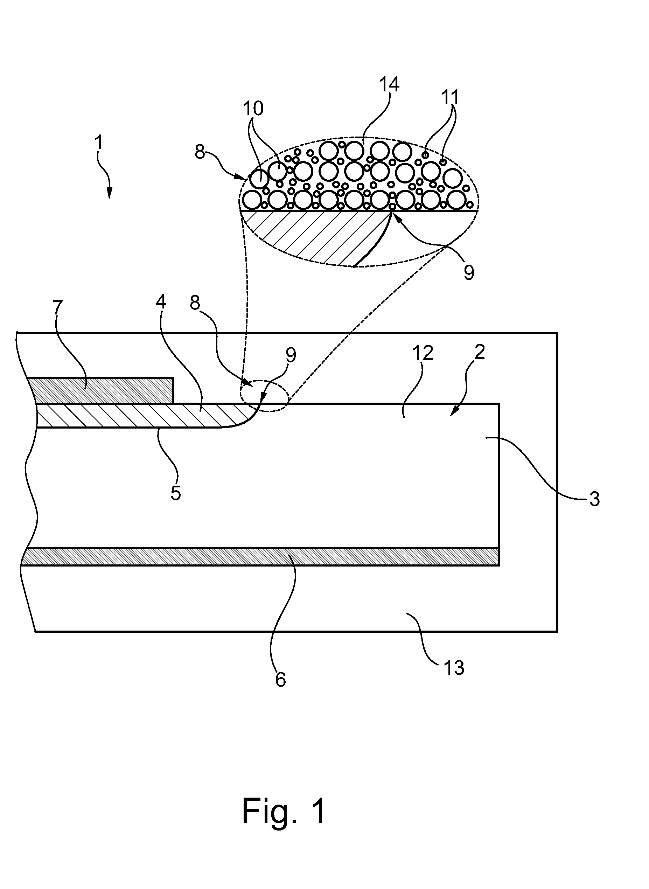

FIG 1: shows a high voltage semiconductor device according to an embodiment of the present invention.

The reference symbols used in the figure and their meaning are summarized in the list of reference symbols. The drawing is only schematically and not to scale. The described embodiment is meant as an example and shall not confine the invention.

### MODES FOR CARRYING OUT THE INVENTION

Fig. 1 shows a high voltage semiconductor device 1 comprising a planar semiconductor substrate 2. The semiconductor substrate 2 is a silicon wafer having a base doping of a first polarity, e.g. p-type. A major portion of the semiconductor substrate 2 forms a base or anode region 3 of the high voltage semiconductor device 1. At an upper surface of the semiconductor substrate 2, a cathode region 4 doped with an opposite polarity, e.g. n-type, is provided. At an interface between the anode region 3 and the cathode region 4, a pn-junction 5 is formed. The cathode region 4 extends along a major portion of the upper surface of the semiconductor substrate 2. For example, more than 95 % or even 99 % of the upper surface of the semiconductor substrate 2 are covered by the cathode region 4. Only a small a peripheral region 12 of the upper surface of the semiconductor substrate 2 is not covered by the cathode region 4. This peripheral region 12 may have a width of e.g. a few millimeters or less. The base region 3 is electrically contacted by an anode contact 6. The cathode region 4 is electrically contacted by a cathode contact 7.Anode and cathode contacts 6, 7 are arranged on the surface of the substrate on opposite sides.

At an edge termination 9 positioned between the cathode region 4 and the peripheral region 12, the blocking pn-junction 5 reaches the upper surface of the semiconductor substrate 2. At least in a region adjacent to this edge termination 9, the upper surface of the semiconductor substrate 2 is covered by a grading layer 8 having non-linear electrical resistivity characteristics within a rated voltage range of the high voltage semiconductor device 1.

In the specific embodiment shown in fig. 1, the grading layer 8 is part of an encapsulation 13 which encloses the entire high voltage semiconductor device 1 or at least a peripheral portion thereof. The encapsulation 13 comprises an insulating material such as silicone rubber.

As shown in the enlarged view of fig. 1, the grading layer 8 covering the edge termination 9 comprises the rubber material of the encapsulation 13 forming an insulating matrix material 14. Into this insulating matrix material 14, relatively large first microvaristor particles 10 having a diameter in the order of e.g. 10 µm and significantly smaller resistive or refractive second grading particles 11 are incorporated.

The large microvaristors 10 are zinc-oxide based and provide for highly non-linear electrical resistivity characteristics of the grading layer 8. Alternatively, other materials with internal boundary structures having non-linear electrical resistivity such as components comprising tin oxide (SnO₂), titanium oxide (TiO₂) or titanates (e.g. SrTiOₛ) may be used as microvaristors 10.

The microvaristors 10 serve as an electrically non-linear filler material in the insulating matrix material 14. Since the microvaristors 10 may have a lower limit for their size, a particle distribution may give rise to a certain granularity defined by the particle size of the microvaristors. It might therefore happen that the upper surface of the substrate 2 is not fully covered with microvaristors 10 and field enhancements could occur in spaces between microvaristors 10. In order to avoid excessive localized field enhancements, small second grading particles 11 are arranged in these spaces between large microvaristors 10 and provide for resistive or refractive field grading on a micrometer or sub-micrometer scale. For refractive grading, a high permittivity material such as barium titanate (BaTiOₛ), titanium oxide (TiO₂), other titanates or grapheme oxide may be used. For resistive grading, semiconducting filler particles comprising e.g. tin oxide (SnO₂), carbon based fillers like carbon black, graphene etc. and/or coated micro-mica can be used as preferred material candidates.

Summarizing, benefits of the described embodiment of a high voltage semiconductor device with an edge termination using non-linear resistive field grading may be inter alia (1) limitation of a peak electric field along a silicon-encapsulation interface due to the switching field strength of the field grading material, (2) reduction of the peak electric field in the silicon bulk as compared to a planar configuration without field grading, (3) no need for beveling and successive passivation processes, and (4) improved edge cooling due to i) flat bonding to a heat sink and ii) increased thermal conductivity of the rubber /microvaristor composite (e.g. λ(ZnO microvaristor) = 20 W/mK) as compared to pure rubber.

In another embodiment, the conductivity types of the layers are switched, i.e. all layers of the first conductivity type are p type (cathode region 4) and all layers of the second conductivity type are n type (e.g. anode region 3).

### Reference list

1 : high voltage semiconductor device
2 : semiconductor substrate
3 : anode region
4 : cathode region
5 : pn-junction
6 : anode contact
7 : cathode contact
8 : grading layer
9 : junction termination
10 : sintered first particles (microvaristors)
11: resistive or refractive grading second particles
12 : peripheral region
13 : encapsulation
14 : insulating matrix material

## Claims

1. A high voltage semiconductor device (1) comprising a semiconductor substrate (2) with at least two regions of different conductivity types (3, 4) and at least one junction (5) at which the two differently doped regions (3, 4) adjoin and an edge termination (9) at which the junction (5) reaches a surface of the semiconductor substrate (2),
**characterized in that** the edge termination (9) is covered by a grading layer (8) comprising a matrix material with microvaristors (10) incorporated therein, the microvaristors comprising sintered first particles, which have an internal grain boundary structure, which is responsible for nonlinear electrical properties of the sintered first particles.

2. The high voltage semiconductor device of claim 1, wherein the grading layer (8) has a minimum length L in a direction along the surface of the semiconductor substrate (2) and orthogonal to the edge termination (9), wherein electrical characteristics of the microvaristors are adapted such that a switching field strength E_{switch} of the grading layer (8) is higher than 0.5 times a maximum rated voltage Vₘₐₓ of the high voltage semiconductor device (1) divided by the length L, preferably higher than 0.7 times the maximum rated voltage Vₘₐₓ of the high voltage semiconductor device (1) divided by the length L.

3. The high voltage semiconductor device of one of claims 1 or 2, wherein the material of the grading layer (8) has a non-linearity coefficient α of a characteristic current density (j) - electric field strength (E) - curve (j ∼ E^{α}), the non-linearity coefficient α being larger than 10, preferably larger than 15 and more preferably larger than 20 above a switching field strength E_{switch} of the grading layer (8).

4. The high voltage semiconductor device of one of claims 1 to 3, wherein the matrix material of the grading layer (8) is electrically insulating.

5. The high voltage semiconductor device of one of claims 1 to 4, wherein the microvaristors are based on at least one of zinc oxide, tin oxide, titanium oxide and any other titanate.

6. The high voltage semiconductor device of one of claims 1 to 5, wherein resistive or refractive grading second particles (11) are embedded into the matrix material (14) of the grading layer further, wherein the second grading particles (11) comprise at least one of a semiconductor and a high permittivity material.

7. The high voltage semiconductor device of claim 6, wherein the second grading particles (11) have significantly smaller dimensions than the sintered first particles (10).

8. The high voltage semiconductor device of claim 7, wherein a majority of the microvaristors (10) have sizes of more than 10 µm and wherein a majority of the second grading particles (11) have sizes of less than 3 µm.

9. The high voltage semiconductor device of one of claims 1 to 8, wherein the matrix material (14) comprises at least one of an elastomeric material, a thermoplastic material, a thermosetting material, a gel and a glass.

10. The high voltage semiconductor device of one of claims 1 to 9, wherein the grading layer (8) completely encloses an edge of the semiconductor substrate (2).

11. The high voltage semiconductor device of one of claims 1 to 10, wherein the semiconductor substrate (2) comprises two main sides opposite to each other, wherein the device comprises two electrical contacts, which are arranged on the two main sides, and wherein the substrate has an edge, which is arranged perpendicular to the two main sides.

12. The high voltage semiconductor device of one of claims 1 to 11, wherein the semiconductor device (1) has a rated maximum voltage Vₘₐₓ of above 2 kV.

13. The high voltage semiconductor device of one of claims 1 to 12, wherein the semiconductor device (1) is one of a power rectifier, a thyristor and a diode.
